# EUROPEAN PATENT SPECIFICATION

(11) **EP 1 391 740 B1**
(45) Date of publication and mention of the grant of the patent: **05.05.2010**
(21) Application number: 02716855.8
(22) Date of filing: 21.03.2002
(51) Int. Cl.: G01R 15/14, H01B 17/26

(54) **HIGH-VOLTAGE INSULATED MODULAR CONNECTION SYSTEM WITH CURRENT AND VOLTAGE ACQUISITION**
HOCHSPANNUNGSISOLIERTES MODULARES VERBINDUNGSSYSTEM MIT STROM- UND SPANNUNGSAKQUISITION
SYSTÈME DE CONNEXION MODULAIRE ISOLÉ HAUTE TENSION OPÉRANT PAR CAPTAGE DE COURANT ET DE TENSION

(30) Priority: 30.03.2001 ES 200100753
(43) Date of publication of application: 25.02.2004
(73) Proprietor: Grupo Ormazabal, S.A., 48170 Zamudio (Vizcaya) (ES)
(72) Inventor: ORMAZABAL OCERIN, Javier, E-48170 Zamudio (Vizcaya) (ES)
(74) Representative: Carpintero Lopez, Francisco
(86) International application number: PCT/ES2002/000141
(87) International publication number: WO 2002/080308

(56) References cited:
- EP-A- 0 851 442
- EP-A- 0 917 157
- WO-A-96/11408
- US-A- 4 074 193
- US-A- 6 005 760

## Description

### OBJECT OF THE INVENTION

The present invention relates to a system for isolated connection of high voltage with a current and voltage uptake, the obvious purpose of which is to provide safe connection of a cable to an equipment, with a high level of protection as regards both insulation and shielding, also providing low-signal voltage and current values at the connection point, with these values being proportional to the amplitude of the values of the high-voltage part, so that the corresponding pickups used to measure the voltage and current are integrated directly in the connection system, maintaining the safety, reliability and insulation levels of the installation.

The object of the invention is to provide a system for isolated connection of high voltage that picks up the signals directly from the connection, maintaining the safety, reliability and insulation levels of the installation, eliminating the hazards of electrified areas being exposed to the air and preventing maintenance problems characteristic of conventional systems.

### BACKGROUND OF THE INVENTION

Numerous types of high-voltage measurement systems are known, mainly relying on inductive current and voltage transformers that supply the required power to the electronic protection and measurement equipment, although currently most of these protection and measurement systems are electronic, which results in a power excess that often exceeds the technical and dynamic limits of the protection and measurement equipment, with the ensuing risk of damaging them.

There are various systems in which said powers are reduced, even changing the transformation ratio to obtain wider dynamic ranges; these systems only provide a measure of the current on the high-voltage conductor.

Likewise, resistive splitters are known that provide a signal proportional to the value of the voltage at the high-voltage side, which are provided for points of connection to air so that their use is mostly limited to applications of indicating the presence of a voltage.

For this reason, in order to carry out a joint measurement of the current and the voltage at an input or output point of a high-voltage equipment different elements must be used, among which are always conventional inductive transformers, as well as special connections.

It should be kept in mind that systems based on current and voltage transformers are in first place very large, with active parts connected to the air presenting a potential hazard for the persons who must work in them after start up which, together with the fact that connections to air are added on the high-voltage side, results in a reduced reliability of the equipment connected to it.

In addition, transformers depend on the parameters of the installation and must be replaced if, for example, the power of the installation changes.

In the case of maintenance with high voltage cable tests, in order to keep the applied voltages from affecting conventional transformers these must be first disconnected from the new part, implying a manipulation that affects the continuity of service.

When testing elements connected to the secondary coils of the measurement transformers said secondary coils are short-circuited or isolated when the grid is electrified to prevent damage to the transformers, so that there must be a manual manipulation that can result in a later reduction in the reliability of the assembly in which they are installed.

The european patent application EP-0.851.442 discloses a lead-in insulator comprising a primary conductor (4) housed in a body (5), and voltage and current measuring elements (3) and (2).

### DESCRIPTION OF THE INVENTION

The system taught has been conceived to solve the above-described problems, with the system being meant to establish connection between a cable and an equipment which maintains a high level of insulation and shielding while providing the current and voltage values at the connection point.

The novelty of the invention as defined in claim 1 is that the pickups used to measure the voltage and current are directly integrated in the connection system, maintaining the safety, reliability and insulation levels of the installation.

The current pickup, according to the invention, consists of a ring with winding wrapped around a magnetic material, with a high transformation ratio that confers it a wide dynamic range, with said current pickup being mounted on the corresponding fixed base or bushing of the high-voltage connection. In addition, said current pickup also includes a current limiter comprised of a semiconductor to facilitate disconnection of the signal cable during maintenance operations without having to short-circuit the output.

On its part the voltage pickup, according to the invention, is integrated in the separable connector or bushing without altering any characteristics of the high-voltage connection. Said voltage pickup is comprised of a resistance associated to metal inserts that correspond to the electrodes of the electrical circuit provided for protection, measurement and control, such that the voltage pickup also includes a voltage limiter that allows performing maintenance tasks when the connection is electrified, without having to isolate the output.

As regards the electronic circuit for signal pickup, it incorporates an internal treatment of the specific pickup signals, ensuring that the operational conditions of the assembly are those required to obtain the accuracy specifications of the system.

Said electronic circuit can be embodied as a protection relay adapted to process low-power signals, so that said relay, mono-phasic and/or tri-phasic, can perform overcurrent, undervoltage, overvoltage, frequency and/or power functions.

Said electronic circuit can also consist of a measurement and/or billing device adapted to process low-power signals, that in any case can include amplification functions to provide standardized output values of voltage and current similar to those of conventional transformers.

The system as a whole can work as a current pickup only, being used for protection, measurement and/or control functions of an electronic equipment, or it can work as a voltage pickup only, for protection, measurement and/or control functions of an electronic equipment.

### DESCRIPTION OF THE DRAWINGS

In order to complement the description being made and to aid a better understanding of the characteristics of the invention, according to an example of a preferred embodiment, a set of drawings is accompanied as an integral part of the description where for purposes of illustration and in a non limiting sense the following is shown:
Figure 1 shows a representation of a specific application of the insulated high-voltage connection system with current and voltage uptake, all according to the object of the invention.
Figure 2 shows the electrical scheme of the current pickup.
Figure 3 shows, finally, the scheme of the voltage uptake circuit.

### PREFERRED EMBODIMENT OF THE INVENTION

As can be seen in the above-described figures, the system of the invention is meant to establish a connection or union between a single wire (1) and an integral isolation system (2), with the system including a current pickup (3) and a voltage pickup (4), the former for measuring the current and the latter for measuring the voltage.

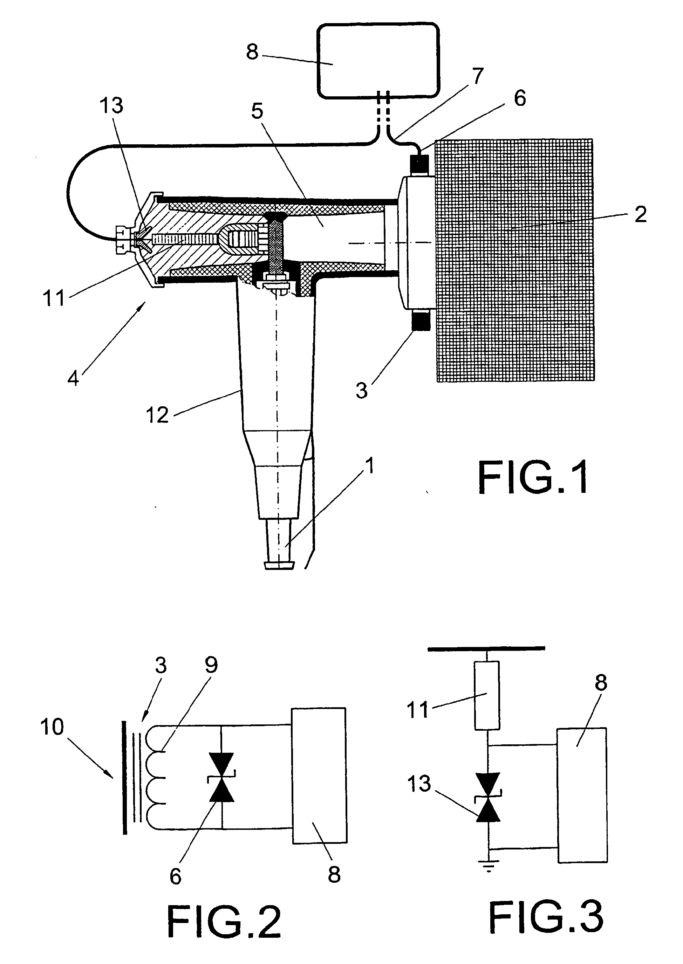

The current pickup (3) consists of a ring with winding wrapped around a magnetic material, with a high transformation ratio that confers it a wide dynamic range, mounted on the fixed base of connection of the equipment (2) specifically embracing the base of the insulated bushing (5), with said current pickup (3) including a current limiter (6) for disconnecting the corresponding signal cable (7) from an electronic device (8) for signal uptake; said limiter (6), as shown in figure 2, is embodied as a semi-conductor with bi-directional limitation capable of absorbing the power of the winding of the secondary coil (9) with the transformer (10) in open circuit.

On its part, the voltage pickup is integrated in the bushing for connection to the high-voltage conductor (1), and consists of a precision resistance (11) together with metal inserts embedded in resin, with said inserts corresponding to the electrodes of the electric circuit defined by the aforementioned resistance (11) and the signal input of the electronic equipment (8), between the active high-voltage point and the earth connection of the installation, so that the earthing electrode acts as a heat dissipator to ensure that the resistance temperature remains within the limits in which its accuracy is maintained.

Said voltage pickup(4) also includes a voltage limiter (13) consisting of a semi-conductor that can perform system maintenance functions when the connection is electrified without requiring isolating the output, as occurs with the current limiter (6) of the current pickup (3).

The voltage limiter (13) maintains the maximum voltage value obtained at the pickup output at levels slightly above nominal values.

The current and voltage signals are treated and processed by the electronic circuit or equipment (8) provided for protection, measurement and/or control, with the latter being provided with specific input measurement devices to qualify the signals arriving from the pickups; these measurement devices have a very high input impedance in the case of the voltage uptake, which is achieved by internal isolation transformers with a large number of coils, working in an open circuit, while in the case of current uptake the input measurement has a near-zero impedance by means of an internal toroidal transformer working in short-circuit with the secondary.

Among the main functions of said electronic circuit (8) is that of acting as a protection relay for both current and voltage functions, as well as carrying out direct measurements at the terminals of the grid parameters and amplification of input signals to standardized values similar to those of conventional measurement transformers.

## Claims

1. Connection system for the isolated connection of a cable (1) to a high voltage equipment (2), the system comprising an insulating bushing (5) and a connection terminal (12) configured to be coupled to said insulating bushing (5) for connecting said cable to said equipment (2), and an electronic circuit (8) electrically connected to said connection system for receiving voltage and current measurements at the connection point with said equipment, the system further comprising voltage and current measurement elements integrated in said connection system, **characterised in that** the current measurement element (3) consists of a toroidal inductive current measurement element which is mounted around a fixed base of the cited insulating bushing (5), and wherein said voltage measurement element (4) consists of a resistive element (11) integrated in a separable connector connected to the connection terminal (12) and wherein said electronic circuit (8) is connected to said voltage and current measurement elements (3,4) and comprises means for treating the signals provided by said measurement elements (3,4).

2. Connection system according to claim 1 wherein said connection terminal (12) is a T-shaped terminal, having a central arm housing said cable (1), a first side arm coupled to the insulating bushing (5), and said separable connector housed in a second side arm, wherein said resistive element (11) is integrated in said separable connector.

3. Connection system according to claim 1, **characterized in that** the electronic circuit (8) for picking up signals consist of a protection relay adapted to process low-power signals, or a measurement device also adapted to process low-power signals.

4. Connection system according to the previous claims, **characterized in that** the electronic circuit (8) includes amplification functions to provide standardized output voltage and current values similar to those of conventional transformers.

## Patentansprüche

1. Verbindungssystem für die isolierte Verbindung eines Kabels (1) mit einer Hochspannungseinrichtung (2), wobei das System eine isolierende Durchführung (5) und einen Verbindungsanschluss (12), welcher gestaltet ist, mit der isolierenden Durchführung (5) gekoppelt zu sein, zum Verbinden des Kabels mit der Einrichtung (2), und eine elektronische Schaltung (8) aufweist, welche elektrisch mit dem Verbindungssystem verbunden ist, zum Empfangen von Strom- und Spannungsmessungen an dem Punkt der Verbindung mit der Einrichtung, wobei das System ferner Spannungs- und Strommesselemente umfasst, welche in das Verbindungssystem integriert sind, **dadurch gekennzeichnet, dass** das Strommesselement (3) in einem toroidförmigen induktiven Strommessungselement besteht, welches um eine fixe Basis der isolierenden Durchführung (5) herum befestigt ist, wobei das Spannungsmesselement (4) aus einem Widerstandselement (11) besteht, welches in einen trennbaren Verbinder integriert ist, der mit dem Verbindungsanschluss (12) verbunden ist, und wobei die elektronische Schaltung (8) mit den Spannungs- und Strommesselementen (3, 4) verbunden ist und Mittel umfasst zum Behandeln der Signale, welche durch die Messelemente (3, 4) bereitgestellt werden.

2. Verbindungssystem nach Anspruch 1, wobei der Verbindungsanschluss (12) ein T-förmiger Anschluss ist, welcher einen neutralen Arm aufweist, der das Kabel (1) aufnimmt, einen mit der isolierenden Durchführung (5) gekoppelten Arm an der ersten Seite und den trennbaren Verbinder, der in einem Arm an der zweiten Seite aufgenommen ist, wobei das Widerstandselement (11) in den trennbaren Verbinder integriert ist.

3. Verbindungssystem nach Anspruch 1, **dadurch gekennzeichnet, dass** die elektronische Schaltung (8) zum Erfassen der Signale aus einem Schutzrelais, welches angepasst ist, Signale geringer Spannung zu verarbeiten, oder in einer Messvorrichtung besteht, welche ebenfalls angepasst ist, Signale geringer Spannung zu verarbeiten.

4. Verbindungssystem nach den vorhergehenden Ansprüchen, **dadurch gekennzeichnet, dass** die elektronische Schaltung (8) Verstärkungsfunktionen aufweist, um standardisierte Ausgangswerte für Spannung und Strom bereitzustellen, ähnlich jenen von konventionellen Umformern.

## Revendications

1. Système de raccordement pour le raccordement isolé d'un câble (1) à un équipement haute tension (2), le système comprenant un manchon de traversée isolant (5) et une borne de raccordement (12) configurée pour être couplée audit manchon de traversée isolant (5) pour le raccordement dudit câble audit équipement (2), et un circuit électronique (8) relié électriquement audit système de raccordement pour recevoir des mesures de tension et de courant au niveau du point de raccordement avec ledit équipement, le système comprenant en outre des éléments de mesure de tension et de courant intégrés dans ledit système de raccordement, **caractérisé en ce que** l'élément de mesure de courant (3) consiste en un élément de mesure de courant torique à induction qui est monté autour d'une base fixe dudit manchon de traversée isolant (5), et dans lequel ledit élément de mesure de tension (4) consiste en un élément résistif (11) intégré dans un connecteur séparable raccordé à la borne de raccordement (12) et dans lequel ledit circuit électronique (8) est raccordé auxdits éléments de mesure de tension et de courant (3, 4) et comprend des moyens pour traiter les signaux fournis par lesdits éléments de mesure (3, 4).

2. Système de raccordement selon la revendication 1, dans lequel ladite borne de raccordement (12) est une borne en forme de T, présentant un bras central logeant ledit câble (1), un premier bras latéral couplé au manchon de traversée isolant (5), et ledit connecteur séparable étant logé dans un deuxième bras latéral, dans lequel ledit élément résistif (11) est intégré dans ledit connecteur séparable.

3. Système de raccordement selon la revendication 1, **caractérisé en ce que** le circuit électronique (8) pour capter des signaux consiste en un relais de protection adapté pour traiter des signaux de faible puissance, ou un dispositif de mesure également adapté pour traiter des signaux de faible puissance.

4. Système de raccordement selon les revendications précédentes, **caractérisé en ce que** le circuit électronique (8) comprend des fonctions d'amplification pour fournir des valeurs standardisées de courant et de tension de sortie similaires à celles des transformateurs traditionnels.
